# EUROPEAN PATENT APPLICATION

(11) **EP 4 737 923 A1**
(43) Date of publication of application: **06.05.2026**
(21) Application number: 24772548.4
(22) Date of filing: 09.08.2024
(51) Int. Cl.: G01R 31/385, G01R 31/389, G01R 31/392, H01M 10/48, H01M 50/581

(54) **CELL THERMAL RUNAWAY DETECTION AND LOCATING METHOD AND APPARATUS FOR BATTERY SYSTEM**

(30) Priority: 07.08.2024 CN 202411077171
(71) Applicant: Guangzhou Amphenol Sincere Flex Circuits Co., Ltd, Guangzhou, Guangdong 511480 (CN)
(72) Inventor: CHEN, Jiawen, Guangzhou, Guangdong 511480 (CN); SUN, Junpeng, Guangzhou, Guangdong 511480 (CN); YU, Min, Guangzhou, Guangdong 511480 (CN); LI, Jianhui, Guangzhou, Guangdong 511480 (CN); SUN, Gaixian, Guangzhou, Guangdong 511480 (CN)
(74) Representative: Elzaburu S.L.P.
(86) International application number: PCT/CN2024/110922
(87) International publication number: WO 2026/031139

(57) **Abstract**

The present disclosure provides a method for detecting and locating thermal runaway of a battery cell in a battery system. The method includes: obtaining a quantity of battery cells in a battery system; setting a same quantity of resistors with different resistance values based on the quantity of battery cells; connecting a temperature switch in parallel to each resistor, and connecting each parallel unit in series; placing the temperature switch in each parallel unit connected in series on an explosion-proof valve area of each battery cell; labeling the resistor in each parallel unit connected in series with a different resistance value for each battery cell; determining a total resistance value after the series connection in the battery system; and when the total resistance value after the series connection is a labeled resistance value of a corresponding battery cell, determining that the corresponding battery cell undergoes thermal runaway. In this way, a position of a specific runaway battery cell can be located accurately, thereby performing fire prevention and extinguishing accurately to reduce a risk of a safety accident caused by combustion of the battery system and minimize a loss.

## Description

### TECHNICAL FIELD

The present disclosure relates to the field of power batteries, and in particular, to a method and device for detecting and locating thermal runaway of a battery cell in a battery system.

### BACKGROUND

Thermal runaway of a battery cell in a battery system may lead to battery failure or even combustion, causing a safety accident. Therefore, when the thermal runaway occurs, it is necessary to perform detection and pre-warning in a timely manner to ensure that vehicles and personnel take action measures to reduce a risk and minimize a loss. In the prior art, one method is to install a thermal runaway gas detection sensor in the battery system, such that whether the thermal runaway occurs is determined by detecting a composition of gas erupted after the thermal runaway of the battery cell. However, the gas detection sensor in this method is affected by a type and a concentration of the gas. Under a low concentration, a false alarm may be easily reported due to external environmental interference, or under a high concentration, a pre-warning signal is delayed, making it impossible to locate a position of a specific runaway battery cell and perform fire prevention and extinguishing accurately. Another method is to install a thermal runaway gas pressure sensor in the battery system, such that whether the thermal runaway occurs is determined by detecting gas pressure in the system after the thermal runaway of the battery cell. However, the gas pressure sensor method is affected by a magnitude of the gas pressure. When the battery cell slowly undergoes runaway, an explosion-proof valve of the battery cell slowly releases gas, and the gas communicates with the outside of the battery system through a vent valve to release pressure. This makes it difficult to quickly establish pressure that can be detected by the pressure sensor inside the battery system, resulting in delayed sending of an early warning of the thermal runaway. As a result, it is impossible to locate the position of the specific runaway battery cell and perform the fire prevention and extinguishing accurately. Still another method is to detect changes in a monomer voltage and a temperature of the battery cell to determine whether the thermal runaway occurs. However, when it is determined, based on the changes in the monomer voltage and the temperature of the battery cell, that the battery cell undergoes the thermal runaway, a voltage change of the battery cell cannot be easily identified due to an impact from an internal status of the battery cell, resulting in misjudgment or delayed pre-warning. For example, when monomers of battery cells are connected in parallel, a detected voltage remains unchanged when one of the parallel battery cells undergoes the thermal runaway. As a result, this causes a misjudgment, which makes it impossible to locate the position of the specific runaway battery cell and perform the fire prevention and extinguishing accurately.

### SUMMARY

An objective of the present disclosure is to provide a method and device for detecting and locating thermal runaway of a battery cell in a battery system, which can locate a position of a specific runaway battery cell, so as to perform fire prevention and extinguishing accurately to reduce a risk and minimize a loss.

A method for detecting and locating thermal runaway of a battery cell in a battery system in the present disclosure includes following steps:
S1: obtaining a quantity of battery cells in a battery system;
S2: setting a same quantity of resistors with different resistance values based on the quantity of battery cells;
S3: connecting a temperature switch in parallel to each resistor, and connecting each parallel unit in series;
S4: placing the temperature switch in each parallel unit connected in series on an explosion-proof valve area of each battery cell;
S5: labeling the resistor in each parallel unit connected in series with a different resistance value for each battery cell; and
S6: determining a total resistance value after the series connection in the battery system; and when the total resistance value after the series connection is a labeled resistance value of a corresponding battery cell, determining that the corresponding battery cell undergoes thermal runaway.

As a preferred solution of the present disclosure, in the step S6, when the total resistance value after the series connection is equal to a resistance value of a circuit itself plus a resistance value of a temperature switch, it is determined that no thermal runaway occurs in the battery cell in the battery system.

As a preferred solution of the present disclosure, a threshold for disconnecting the temperature switch is less than a threshold for breaking through the explosion-proof valve area of the battery cell.

As a preferred solution of the present disclosure, the temperature switch is a PTC fuse switch.

As a preferred solution of the present disclosure, thermally conductive copper foils are respectively provided on two ends of a pad of the PTC fuse switch on the explosion-proof valve area of the battery cell.

As a preferred solution of the present disclosure, pre-stress grooves are provided on an explosion-proof cover plate on the explosion-proof valve area of the battery cell, and respectively disposed on two sides of each of the two thermally conductive copper foils.

As a preferred solution of the present disclosure, the pre-stress groove is an H-shaped pre-stress groove, and the two thermally conductive copper foils at the two ends of the pad of the PTC fuse switch each are provided with a circuit lead that longitudinally passes through the H-shaped pre-stress groove and is connected to two terminals of the resistor connected in parallel to the PTC fuse switch.

A device for detecting and locating thermal runaway of a battery cell in a battery system is provided, where resistors with a same quantity as battery cells and different resistance values are disposed, each resistor is connected in parallel to a temperature switch, and each parallel unit is connected in series, an explosion-proof cover plate is disposed on an explosion-proof valve area of the battery cell, the temperature switch in each parallel unit connected in series is placed on the explosion-proof cover plate corresponding to each battery cell, and each resistor is labeled with a different resistance value.

As a preferred solution of the present disclosure, the temperature switch is a PTC fuse switch.

As a preferred solution of the present disclosure, thermally conductive copper foils are respectively disposed at two ends of a pad of the PTC fuse switch on the explosion-proof valve area of the battery cell, pre-stress grooves are provided on the explosion-proof cover plate, and respectively disposed on two sides of each of the two thermally conductive copper foils, the pre-stress groove is an H-shaped pre-stress groove, and the two thermally conductive copper foils at the two ends of the pad of the PTC fuse switch each are provided with a circuit lead that longitudinally passes through the H-shaped pre-stress groove and is connected to two terminals of the resistor connected in parallel to the PTC fuse switch.

According to the method and device for detecting and locating thermal runaway of a battery cell in a battery system, the temperature switch in each parallel unit connected in series is placed on the explosion-proof valve area of each battery cell, and different resistance values are labeled. When the total resistance value after the series connection is the labeled resistance value of the corresponding battery cell, a position of a specific runaway battery cell can be located accurately, thereby performing fire prevention and extinguishing accurately to reduce a risk of a safety accident caused by combustion of the battery system and minimize a loss.

### BRIEF DESCRIPTION OF THE DRAWINGS

FIG. 1 is a schematic flowchart of a method for detecting and locating thermal runaway of a battery cell in a battery system according to the present disclosure;
FIG. 2 is a circuit diagram of connecting a resistor and a temperature switch in parallel according to the present disclosure;
FIG. 3 is a schematic diagram of a device for detecting and locating thermal runaway of a battery cell in a battery system; and
FIG. 4 is a partial enlarged view of part A shown in FIG. 3.

### DETAILED DESCRIPTION OF THE EMBODIMENTS

The technical solutions in the embodiments of the present disclosure are described below clearly and completely with reference to the accompanying drawings. Apparently, the described embodiments are merely some rather than all of the embodiments of the present disclosure. All other embodiments obtained by those of ordinary skill in the art based on the embodiments of the present disclosure without creative efforts should fall within the protection scope of the present disclosure.

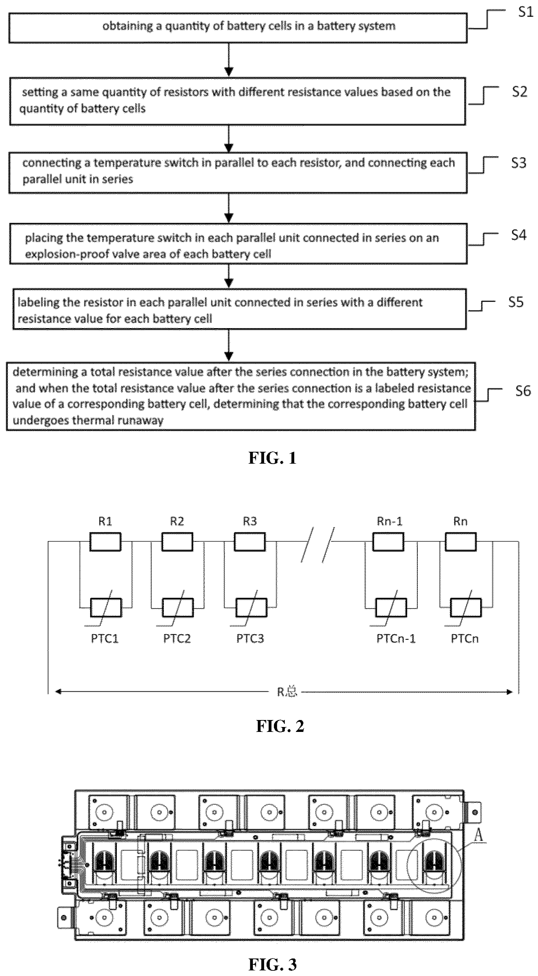

As shown FIG. 1, a method for detecting and locating thermal runaway of a battery cell in a battery system includes following steps:
S1: A quantity of battery cells in a battery system is obtained.
   A quantity of battery cells currently connected to the battery system is directly obtained from the battery system.
S2: A same quantity of resistors with different resistance values is set based on the quantity of battery cells.
   Each battery cell is correspondingly equipped with one resistor, and each resistor has a different resistance value. The resistor is an ordinary resistor.
S3: A temperature switch is connected in parallel to each resistor, and each parallel unit is connected in series.
   The temperature switch is connected in parallel to each resistor. The temperature switch may be a PTC fuse switch. A threshold for disconnecting the PTC fuse switch is less than a threshold for breaking through an explosion-proof valve area of the battery cell, thus achieving two functions: early prevention and failure detection. When a temperature of the battery cell rises to the threshold for disconnecting the PTC fuse switch but does not reach the threshold for breaking through the explosion-proof valve area of the battery cell the threshold for breaking through the explosion-proof valve area of the battery cell is not broken through, heat of the battery cell excites the temperature switch through thermal conduction, thermal radiation, or other forms, thereby achieving pre-warning. When thermal runaway of the battery cell is intensified and the explosion-proof valve area of the battery cell is broken through, high-temperature and high-pressure gas or flame can excite the PTC fuse switch or damage a circuit in the PTC fuse switch area, resulting in an open circuit, thereby achieving thermal runaway detection.
S4: The temperature switch in each parallel unit connected in series is placed on the explosion-proof valve area of each battery cell.
   A pre-stress groove is disposed on an explosion-proof cover plate on the explosion-proof valve area of the battery cell. The pre-stress groove is an H-shaped pre-stress groove and located on two sides of two thermally conductive copper foils. The two thermally conductive copper foils at two ends of the pad of the PTC fuse switch each are provided with a circuit lead that longitudinally passes through the H-shaped pre-stress groove and is connected to two terminals of the resistor connected in parallel to the PTC fuse switch. The thermally conductive copper foil transfers heat efficiently. When the battery cell erupts, heat is thermally conducted to the PTC fuse switch through the large-area copper foil because the thermally conductive copper foil is arranged above an explosion-proof valve of the battery cell, thereby exciting a function of the PTC fuse switch more efficiently and further locating a position of a specific runaway battery cell more quickly. In addition, the pre-stress groove is designed as the H-shaped pre-stress groove, and the high-pressure gas erupted by the battery cell is released through an H-shaped pre-stress groove area. When there is sufficient pressure, the H-shaped pre-stress groove can break the circuit leads at the two ends of the pad of the PTC fuse switch, further locating the position of the specific runaway battery cell more quickly.
S5: The resistor in each parallel unit connected in series is labeled with a different resistance value for each battery cell.
S6: A total resistance value after the series connection in the battery system is determined; and when the total resistance value after the series connection is a labeled resistance value of a corresponding battery cell, it is determined that the corresponding battery cell undergoes the thermal runaway. When the total resistance value after the series connection is equal to a resistance value of a circuit itself plus a resistance value of a temperature switch, it is determined that no thermal runaway occurs in the battery cell in the battery system.

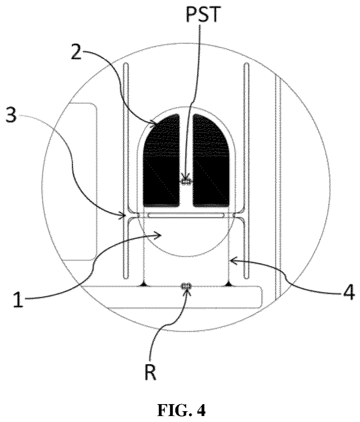

A device for detecting and locating thermal runaway of a battery cell in a battery system is provided. As shown in FIG. 2 to FIG. 4, resistors R with a same quantity as battery cells and different resistance values are disposed, each resistor is connected in parallel to temperature switch PTC, and each parallel unit is connected in series. Explosion-proof cover plate 1 is disposed on an explosion-proof valve area of the battery cell, the temperature switch in each parallel unit connected in series is placed on the explosion-proof cover plate corresponding to each battery cell, and each resistor is labeled with a different resistance value.

The temperature switch in each parallel unit connected in series is placed on the explosion-proof valve area of each battery cell, and different resistance values are labeled. When a total resistance value after the series connection is a labeled resistance value of a corresponding battery cell, a position of a specific runaway battery cell can be located accurately, thereby performing fire prevention and extinguishing accurately to reduce a risk of a safety accident caused by combustion of the battery system and minimize a loss.

The temperature switch is a PTC fuse switch. Thermally conductive copper foil 2 is separately disposed at two ends of a pad of the PTC fuse switch on the explosion-proof valve area of each battery cell. Pre-stress grooves are provided on the explosion-proof cover plate, and respectively disposed on two sides of each of the two thermally conductive copper foils. The pre-stress groove is H-shaped pre-stress groove 3, and the two thermally conductive copper foils at the two ends of the pad of the PTC fuse switch each are provided with circuit lead 4 that longitudinally passes through the H-shaped pre-stress groove and is connected to two terminals of the resistor connected in parallel to the PTC fuse switch.

The thermally conductive copper foil transfers heat efficiently. When the battery cell erupts, heat is thermally conducted to the PTC fuse switch through the large-area copper foil because the thermally conductive copper foil is arranged above an explosion-proof valve of the battery cell, thereby exciting a function of the PTC fuse switch more efficiently and further locating the position of the specific runaway battery cell more quickly. In addition, the pre-stress groove is designed as the H-shaped pre-stress groove, and the high-pressure gas erupted by the battery cell is released through an H-shaped pre-stress groove area. When there is sufficient pressure, the H-shaped pre-stress groove can break the circuit leads at the two ends of the pad of the PTC fuse switch, further locating the position of the specific runaway battery cell more quickly.

The initially designed resistance before a resistor and a PTC fuse switch of a circuit itself are excited is set to be small enough to have no impact on a circuit detection unit and system. For the convenience of demonstrating a calculation principle, assuming that the value is 0, a method for detecting and locating thermal runaway of the battery cell in the battery system is shown in Table 1:

| Battery cell | Battery cell 1 | Battery cell 2 | Battery cell 3 | Battery cell 4 | Battery cell 5 |
|---|---|---|---|---|---|
| Resistor R | R1=1KΩ | R2=2KΩ | R3=3KΩ | R4=4KΩ | R5=5KΩ |
| Status of the temperature switch | On | On | Off | On | On |
| Resistance | RPTC1=0 | RPTC2=0 | RPTC3 is | RPTC4=0 | RPTC5=0 |
| PRTC of the temperature switch | | | infinite | | |
| Resistance RT of the parallel unit | 0KΩ | 0KΩ | 3KΩ | 0KΩ | 0KΩ |

Total resistance: RT1=(R1* RPTC1)/(R1+RPTC1)=(1*0)/(1+0)=0KΩ; RT2=(R2* RPTC2)/(R2+ RPTC2)= (2*0)/(2+0)=0KΩ; RT3=(R3* RPTC3)/(R3+ RPTC3)= (3*∞)/(3+∞)=3KΩ; RT4=(R4* RPTC4)/(R4+ RPTC4)=(4*0)/(4+0)=0KΩ; RT5=(R5*RPTC5)/(R5+RPTC5)=(5*0)/(5+0)=0KΩ. Total RT=RT1+RT2+RT3+RT4+RT5=0+0+3+0+0=3 KΩ. Therefore, the total resistance of the circuit is R3, such that a position of the specific runaway battery cell 3 can be located accurately. The above embodiments are merely intended to describe the detailed solutions of the present disclosure, but the present disclosure is not limited to the above detailed solutions, that is, the present disclosure can be implemented without depending on the above detailed solutions. Those skilled in the art should understand that any improvement to the present disclosure, equivalent replacement of each raw material of the product of the present disclosure, addition of auxiliary ingredients, selection of specific methods, and the like all fall within the protection scope and disclosure scope of the present disclosure.

## Claims

1. A method for detecting and locating thermal runaway of a battery cell in a battery system, comprising following steps:
S1: obtaining a quantity of battery cells in a battery system;
S2: setting a same quantity of resistors with different resistance values based on the quantity of battery cells;
S3: connecting a temperature switch in parallel to each resistor, and connecting each parallel unit in series;
S4: placing the temperature switch in each parallel unit connected in series on an explosion-proof valve area of each battery cell;
S5: labeling the resistor in each parallel unit connected in series with a different resistance value for each battery cell; and
S6: determining a total resistance value after the series connection in the battery system; and when the total resistance value after the series connection is a labeled resistance value of a corresponding battery cell, determining that the corresponding battery cell undergoes thermal runaway.

2. The method for detecting and locating thermal runaway of a battery cell in a battery system according to claim 1, wherein in the step S6, when the total resistance value after the series connection is equal to a resistance value of a circuit itself plus a resistance value of a temperature switch, it is determined that no thermal runaway occurs in the battery cell in the battery system.

3. The method for detecting and locating thermal runaway of a battery cell in a battery system according to claim 1, wherein a threshold for disconnecting the temperature switch is less than a threshold for breaking through the explosion-proof valve area of the battery cell.

4. The method for detecting and locating thermal runaway of a battery cell in a battery system according to claim 1, wherein the temperature switch is a PTC fuse switch.

5. The method for detecting and locating thermal runaway of a battery cell in a battery system according to claim 4, wherein thermally conductive copper foils are respectively provided on two ends of a pad of the PTC fuse switch on the explosion-proof valve area of the battery cell.

6. The method for detecting and locating thermal runaway of a battery cell in a battery system according to claim 5, wherein pre-stress grooves are provided on an explosion-proof cover plate on the explosion-proof valve area of the battery cell, and respectively disposed on two sides of each of the two thermally conductive copper foils.

7. The method for detecting and locating thermal runaway of a battery cell in a battery system according to claim 6, wherein the pre-stress groove is an H-shaped pre-stress groove, and the two thermally conductive copper foils at the two ends of the pad of the PTC fuse switch each are provided with a circuit lead that longitudinally passes through the H-shaped pre-stress groove and is connected to two terminals of the resistor connected in parallel to the PTC fuse switch.

8. A device for detecting and locating thermal runaway of a battery cell in a battery system, comprising resistors with a same quantity as battery cells and different resistance values, wherein a temperature switch is connected in parallel to each resistor, and each parallel unit is connected in series, an explosion-proof cover plate is disposed on an explosion-proof valve area of the battery cell, the temperature switch in each parallel unit connected in series is placed on the explosion-proof cover plate corresponding to each battery cell, and each resistor is labeled with a different resistance value.

9. The device for detecting and locating thermal runaway of a battery cell in a battery system according to claim 8, wherein the temperature switch is a PTC fuse switch.

10. The device for detecting and locating thermal runaway of a battery cell in a battery system according to claim 9, wherein thermally conductive copper foils are respectively disposed at two ends of a pad of the PTC fuse switch on the explosion-proof valve area of the battery cell, pre-stress grooves are provided on the explosion-proof cover plate, and respectively disposed on two sides of each of the two thermally conductive copper foils, the pre-stress groove is an H-shaped pre-stress groove, and the two thermally conductive copper foils at the two ends of the pad of the PTC fuse switch each are provided with a circuit lead that longitudinally passes through the H-shaped pre-stress groove and is connected to two terminals of the resistor connected in parallel to the PTC fuse switch.
